(19)

Europäisches
Patentamt
European
Patent Office
Office européen
des brevets

(11) **EP 2 879 222 B1**

(12) **EUROPEAN PATENT SPECIFICATION**

(45) Date of publication and mention
of the grant of the patent:
**03.05.2017  Bulletin 2017/18**

(51) Int Cl.:
*H01M 8/18* *(2006.01)*       *H01M 8/04* *(2016.01)*
*H01M 8/04186* *(2016.01)*    *G01R 31/36* *(2006.01)*

(21) Application number: **14194621.0**

(22) Date of filing: **25.11.2014**

(54) **Method and apparatus for analyzing electrolyte of redox flow battery**

Verfahren und Vorrichtung zur Analyse eines Elektrolyten einer Redox-Durchflussbatterie

Procédé et appareil pour analyser un électrolyte de batterie à flux redox

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **29.11.2013   KR 20130147530**

(43) Date of publication of application:
**03.06.2015   Bulletin 2015/23**

(73) Proprietor: OCI Company Ltd.
**Seoul 100-718 (KR)**

(72) Inventors:
 • **Hong, Min-Ki
   462-807 Gyeonggi-do (KR)**

 • **Kang, Byung-Man
   462-807 Gyeonggi-do (KR)**
 • **Kim, Soo-Whan
   462-807 Gyeonggi-do (KR)**
 • **Kim, Byung-Chul
   462-807 Gyeonggi-do (KR)**
 • **Ye, Hee-Chang
   462-807 Gyeonggi-do (KR)**

(74) Representative: **Zacco Sweden AB
   P.O. Box 5581
   114 85 Stockholm (SE)**

(56) References cited:
   WO-A2-2012/135473     CN-A- 102 621 085
   JP-A- 2009 016 217

EP 2 879 222 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

This application claims the benefit of Korean Patent Application No. 10-2013-0147530, filed on November 29, 2013, entitled "METHOD AND APPARATUS FOR ANALYZING ELECTROLYTE OF REDOX FLOW BATTERY".

## BACKGROUND

### 1. Technical Field

The present invention relates to a method and apparatus for analyzing an electrolyte of a redox flow battery, and more particularly, to a method and apparatus for analyzing the amount and oxidation number of an electrolyte contained in an electrolyte solution of a redox flow battery.

### 2. Description of the Related Art

Typical secondary batteries convert input electric energy into chemical energy, store the converted chemical energy through charging, convert the stored chemical energy into electric energy and output the converted electric energy through discharging.

Like typical secondary batteries, redox flow batteries convert input electric energy into chemical energy, store the converted chemical energy through charging, convert the stored chemical energy into electric energy and output the converted electric energy through discharging. However, since redox flow batteries are different from typical secondary batteries in that an electrode active material retaining energy does not exist in a solid state but in a liquid state, a tank is required to store the electrode active material.

Specifically, electrolyte solutions containing electrolytes, namely, anolyte and catholyte solutions act as electrode active materials in redox flow batteries. Transition metal oxide solutions are typical examples of the electrolyte solutions. That is, in the redox flow batteries, the anolyte and catholyte solutions are stored in a tank as a mixture of electrolytes, such as transition metals, oxidation states of which may be changed.

Cell parts generating electric energy in redox flow batteries have the same cathode-ion exchange membrane-anode structure as those of fuel cells. Anolyte and catholyte solutions supplied by pumps contact respective electrodes and transition metal ions contained in the electrolyte solutions undergo oxidation/reductions at contact surfaces, whereby electromotive force by Gibbs free energy is induced. At this time, the electrodes do not directly participate in the reactions and merely aid in oxidation/reduction of the transition metal ions contained in the anolyte and catholyte solutions.

In such redox flow batteries, there is a difference in the amount and oxidation number of electrolytes between two electrodes due to side reaction caused by transfer of electrolytes through an ion exchange membrane or overcharging, resulting in reduction of battery capacity. Therefore, electrolytes must be efficiently managed for stable long-term operation of the batteries. To this end, there is a need for information on the amount and oxidation number of transition metal ions contained in anolyte and catholyte solutions. However, it is impossible to obtain accurate information on electrolytes of redox flow batteries through typical electrolyte analysis methods using redox titration or UV absorption.

## BRIEF SUMMARY

Aspects of the present invention provide a method and an apparatus for analyzing an electrolyte of a redox flow battery, which can more efficiently and easily acquire information on an electrolyte.

In addition, aspects of the present invention provide a method and an apparatus for analyzing an electrolyte of a redox flow battery, which can prevent capacity loss of a redox flow battery by reusing an electrolyte solution used for analysis.

Further, aspects of the present invention provide a method and apparatus for analyzing an electrolyte of a redox flow battery, which can analyze an electrolyte without affecting operation of a redox flow battery.

The present invention is not limited to these aspects, and other aspects and advantages of the present invention not mentioned above will be understood through the following description, and more clearly understood from exemplary embodiments of the present invention. In addition, it will be easily appreciated that the aspects and advantages are realized by features and combination thereof as set forth in claims.

In accordance with one aspect of the present invention, a method of analyzing an electrolyte of a redox flow battery includes: passing a first electrolyte solution or a second electrolyte solution through each of a first auxiliary cell and a second auxiliary cell connected to a main cell and a storage tank; closing at least one of the first auxiliary cell and the second auxiliary cell; applying current to the first auxiliary cell and the second auxiliary cell; creating data by measuring a voltage between the first auxiliary cell and the second auxiliary cell; and analyzing an electrolyte contained in the electrolyte solution in the first auxiliary cell or the second auxiliary cell based on a variation in the voltage between the first auxiliary cell and the second auxiliary cell according to time.

In accordance with another aspect of the present invention, an apparatus for analyzing an electrolyte of a redox flow battery includes: an auxiliary cell controller closing at least one of a first auxiliary cell and a second auxiliary cell connected to a main cell and a storage tank; a current controller applying current to the first auxiliary cell and the second auxiliary cell and measuring a voltage between the first auxiliary cell and the second auxiliary cell; and an analysis unit analyzing an electrolyte contained in an electrolyte solution in the first auxiliary cell or the second auxiliary cell based on a variation in the voltage between the first auxiliary cell and the second auxiliary cell according to time.

In accordance with a further aspect of the present invention, a method of analyzing an electrolyte of a redox flow battery includes: passing a first electrolyte solution or a second electrolyte solution through each of a first auxiliary cell and a second auxiliary cell connected to a main cell and a storage tank; closing at least one of the first auxiliary cell and the second auxiliary cell; applying current to the first auxiliary cell and the second auxiliary cell for a first completion time interval for which a voltage between the first auxiliary cell and the second auxiliary cell reaches a first voltage value; applying current to the first auxiliary cell and the second auxiliary cell for a second completion time interval for which the voltage between the first auxiliary cell and the second auxiliary cell reaches a second voltage value; and analyzing an electrolyte contained in the electrolyte solution in the first auxiliary cell or the second auxiliary cell based on the first completion time interval and the second completion time interval.

In accordance with yet another aspect of the present invention, an apparatus for analyzing an electrolyte of a redox flow battery includes: an auxiliary cell controller closing at least one of a first auxiliary cell and a second auxiliary cell connected to a main cell and a storage tank; a current controller applying current to the first auxiliary cell and the second auxiliary cell for a first completion time interval for which a voltage between the first auxiliary cell and the second auxiliary cell reaches a first voltage value and for a second completion time interval for which the voltage between the first auxiliary cell and the second auxiliary cell reaches a second voltage value; and an analysis unit analyzing an electrolyte contained in an electrolyte solution in the first auxiliary cell or the second auxiliary cell based on the first completion time interval and the second completion time interval.

As described above, according to the present invention, information on an electrolyte can be obtained more efficiently and easily.

In addition, according to the present invention, a redox flow battery can be prevented from suffering capacity loss through reuse of an electrolyte used for analysis.

Further, according to the present invention, an electrolyte can be analyzed without any effects on operation of the redox flow battery.

## BRIEF DESCRIPTION OF THE DRAWINGS

The above and other aspects, features, and advantages of the present invention will become apparent from the detailed description of the following embodiments in conjunction with the accompanying drawings, in which:

Figure 1 is a diagram of a redox flow battery and an electrolyte analysis apparatus connected thereto according to one embodiment of the present invention;
Figure 2 is a detailed view of an electrolyte analysis apparatus according to one embodiment of the present invention;
Figure 3 is a graph showing an electrolyte analysis method according to Example 1 of the present invention;
Figure 4 is a graph showing an electrolyte analysis method according to Example 2 of the present invention;
Figure 5 is a graph showing an electrolyte analysis method according to Example 3 of the present invention;
Figure 6 is a graph showing an electrolyte analysis method according to Example 4 of the present invention;
Figure 7 is a graph showing an electrolyte analysis method according to Example 5 of the present invention;
Figure 8 is a flowchart of an electrolyte analysis method according to one embodiment of the present invention; and
Figure 9 is a flowchart of an electrolyte analysis method according to another embodiment of the present invention.

## DETAILED DESCRIPTION

Hereinafter, Exemplary embodiments of the invention will now be described in detail with reference to the accompanying drawings. It should be understood that the present invention is not limited to the following embodiments and may be embodied in different ways, and that the embodiments are given to provide complete disclosure of the invention and to provide thorough understanding of the invention to those skilled in the art. Herein, detailed descriptions of components and functions apparent to those skilled in the art will be omitted for clarity. Like components will be denoted by like reference numerals throughout the specification and the accompanying drawings.

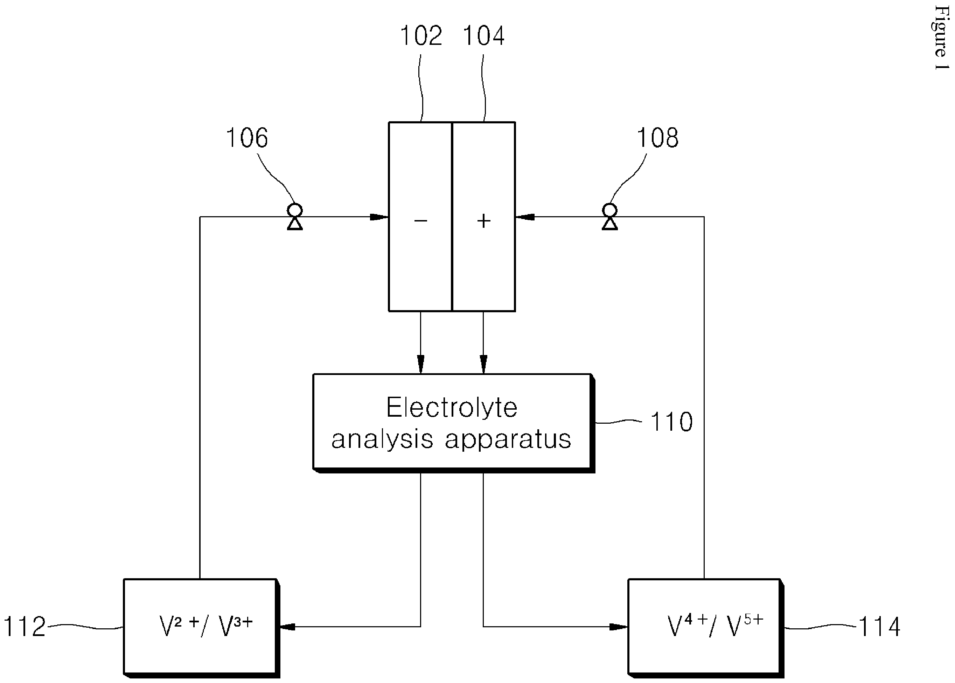

Figure 1 is a diagram of a redox flow battery and an electrolyte analysis apparatus connected thereto according to one embodiment of the present invention.

Referring to Figure 1, a redox flow battery includes two main cells 102, 104, two pumps 106, 108, and storage tanks 112, 114 storing electrolyte solutions.

The two storage tanks 112, 114 store catholyte and anolyte solutions, respectively, which function as electrode active materials, and the electrolyte solutions include electrolytes such as transition metal ions. Although a variety of transition metal ions may be used for oxidation/reductions of the redox flow battery, a redox flow battery using vanadium ions will be described in the embodiment of the present invention.

In the embodiment shown in Figure 1, the storage tank 112 stores a catholyte solution including $V^{2+}$ and $V^{3+}$ ions, and the storage tank 114 stores an anolyte solution including $V^{4+}$ and $V^{5+}$ ions.

The electrolyte solutions stored in the storage tanks 112, 114 are fed into the main cells 102, 104 through the pumps 106, 108, respectively. Oxidation and reduction occur in the first main cell 102 and the second main cell 104 using the fed electrolyte solutions, and thus the redox flow battery is charged and discharged. Although the first main cell 102 is denoted as a cathode cell and the second main cell 104 is denoted as an anode cell in the embodiment shown in Figure 1, polarities of the first main cell 102 and the second main cell 104 may be exchanged in other embodiments.

The electrolyte solutions used for oxidation and reduction in the main cells 102, 104 are transferred to the storage tanks 112, 114 again. Although a single unit cell consisting of the first main cell 102 and the second main cell 104 is shown as one example in Figure 1, the main cell according to the present invention may also have a stack structure including a plurality of unit cells each consisting of the first main cell 102 and the second main cell 104.

Information on the electrolyte solutions must be obtained to efficiently manage the redox flow battery composed as described above. In the present invention, as shown in Figure 1, an electrolyte analysis apparatus 110 is disposed between the first main cell 102 and the second main cell 104 and the storage tanks 112, 114 to analyze the electrolyte solutions while minimizing influence on operation of the redox flow battery.

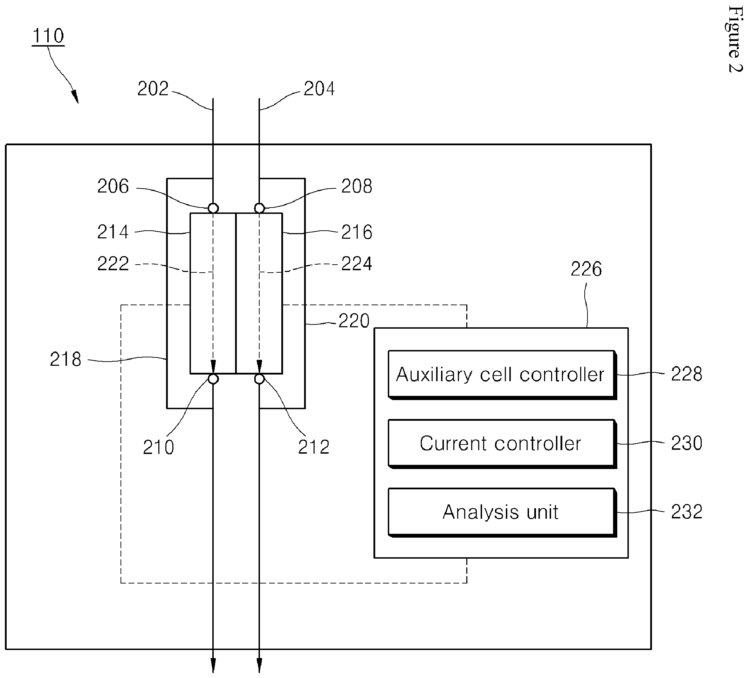

Figure 2 shows detailed configuration of the electrolyte analysis apparatus 110 of Figure 1.

Referring to Figure 2, the electrolyte analysis apparatus 110 includes two auxiliary cells 214, 216, and an analysis module 226.

Main flow paths 202, 204 connected to the electrolyte analysis apparatus 110 are divided into bypass lines 218, 220 and internal lines 222, 224. The two auxiliary cells, namely, the first auxiliary cell 214 and the second auxiliary cell 216 are supplied with catholyte and anolyte solutions through the internal lines 222, 224, respectively. The electrolyte solutions supplied to the first auxiliary cell 214 and the second auxiliary cell 216 through the internal lines 222, 224 may be used to analyze electrolytes. After analysis, the electrolytes solutions are transferred to the storage tanks 112, 114 through the main flow paths.

The electrolyte solutions discharged from the first main cell 102 and the second main cell 104 may be consistently transferred to the storage tank 112, 114 through the bypass lines 218, 220. Therefore, the redox flow battery may continue to be charged and discharged without interruption even while the electrolytes are analyzed through the first auxiliary cell 214 and the second auxiliary cell 216.

Valves 206, 210 are disposed at both ends of the first auxiliary cell 214, and valves 208, 212 are disposed at both ends of the second auxiliary cell 216. The valves 206, 208, 210, 212 may be closed or opened under the control of an auxiliary cell controller 228. The electrolyte solutions introduced into the first auxiliary cell 214 and the second auxiliary cell 216 may be confined in or discharged from the first auxiliary cell 214 and the second auxiliary cell 216 by opening/closing the valves 206, 208, 210, 212. For example, when the auxiliary cell controller 228 controls the valves 206, 210 to be closed, the electrolyte solution introduced into the first auxiliary cell 214 is confined in the first auxiliary cell 214. Though some of the electrolyte solutions are confined in the first auxiliary cell 214 and the second auxiliary cell 216 through the operation of the valves 206, 208, 210, 212, the redox flow battery may continue to operate due to the bypass lines 218, 220.

Although not shown in Figure 2, in other embodiments of the invention, separate internal lines may be further provided in addition to the internal lines 222, 224 shown in Figure 2 such that a first electrolyte solution in the first main cell 102 may flow into the second auxiliary cell 216 and a second electrolyte solution in the second main cell 104 may flow into the first auxiliary cell 214.

The analysis module 226 includes the auxiliary cell controller 228, a current controller 230, and an analysis unit 232.

The auxiliary cell controller 228 may allow the first and/or second electrolyte solution to pass through the first auxiliary cell 214 and the second auxiliary cell 216. In addition, the auxiliary cell controller 228 may confine the electrolyte solutions in the first auxiliary cell 214 and the second auxiliary cell 216 by closing at least one of the first auxiliary cell 214 and the second auxiliary cell 216. Such operation may be performed by opening/closing the valves 206, 208, 210, 212.

For reference, the expression "closing the auxiliary cell" as used herein means prevention of the electrolyte solution from flowing into the corresponding auxiliary cell from the main cell or from flowing out of the corresponding auxiliary cell to the storage tank. That is, "closing the auxiliary cell" means a state that inflow/outflow of the electrolyte solution is physically completely interrupted or a state that the electrolyte solution may be regarded as being substantially interrupted even though infinitesimally introduced into and discharged from the auxiliary cell. Accordingly, when the auxiliary cell is closed, the electrolyte solution in the auxiliary cell may be maintained in a stagnant state or circulated by a separate auxiliary tank and an auxiliary flow path (not shown).

In other embodiments of the invention, the separate internal lines may be further formed as described above in addition to the internal lines 222, 224 shown in Figure 2. In this case, the auxiliary cell controller 228 may allow only one type of electrolyte solution to pass through the first auxiliary cell 214 and the second auxiliary cell 216. For example, the auxiliary cell controller 228 may allow only the first electrolyte solution or only the second electrolyte solution to pass through the first auxiliary cell 214 and the second auxiliary cell 216. In the embodiment of the invention, the current controller 230 applies current to the first auxiliary cell 214 and the second auxiliary cell 216. Then, the current controller 230 may measure a voltage between the first auxiliary cell 214 and the second auxiliary cell 216 depending upon the applied current. The analysis unit 232 may create a graph showing variation in the voltage between the first auxiliary cell 214 and the second auxiliary cell 216 according to measurement time. The analysis unit 232 may analyze electrolytes contained in the first electrolyte solution or the second electrolyte solution using the graph.

In other embodiments of the invention, the current controller 230 may apply current to the first auxiliary cell 214 and the second auxiliary cell 216 until a first completion time that the voltage between the first auxiliary cell 214 and the second auxiliary cell 216 reaches a first voltage, and until a second completion time that the voltage reaches a second voltage. The analysis unit 232 may analyze the electrolytes contained in the first electrolyte solution or the second electrolyte solution based on the first completion time and the second completion time.

Hereinafter, a process of analyzing an electrolyte solution of a redox flow battery by the analysis unit 226 using the first auxiliary cell 214 and the second auxiliary cell 216 will be described with reference to some examples. Although a first electrolyte solution (a catholyte solution) flows into the first auxiliary cell 214 and a second electrolyte solution (an anolyte solution) flows into the second auxiliary cell 216 in the following examples, polarities of the electrolyte solutions flowing into the respective auxiliary cells may be exchanged in other examples. In addition, electrolyte solutions having the same polarity may flow into the respective auxiliary cells in other examples.

## Example 1

Through the following process, the analysis module 226 analyzes a second electrolyte solution flowing into the second auxiliary cell 216.

1) The auxiliary cell controller 228 opens all the valves 206, 208, 210, 212 to allow a first electrolyte solution and a second electrolyte solution to flow into the first auxiliary cell 214 and the second auxiliary cell 216. In other examples in which the separate internal lines are further formed as described above in addition to the internal lines 222, 224 shown in Figure 2, the auxiliary cell controller 228 may also allow electrolyte solutions having the same polarity to flow into the first auxiliary cell 214 and the second auxiliary cell 216.

2) The auxiliary cell controller 228 closes the valves 208, 212 to confine the second electrolyte solution in the second auxiliary cell 216. In other examples, the auxiliary cell controller 228 may also close all the valves 206, 208, 210, 212 of the first auxiliary cell 214 and the second auxiliary cell 216.

3) The current controller 230 applies current to the first auxiliary cell 214 functioning as an anode and the second auxiliary cell 216 functioning as a cathode. Discharge starts (302) when a current of 2A is applied at a voltage of about 1.3 V to the first auxiliary cell 214 and the second auxiliary cell 216 and ends (304) when a voltage between the two auxiliary cells is about -0.15 V. Thereafter, charging starts (306) when a current of 2A having an opposite polarity is applied to the two auxiliary cells and ends (308) at a voltage of 1.5 V. Although a current of 2A is applied to the two auxiliary cells in this example, the magnitude of the applied current may be changed according to examples.

4) The current controller 230 measures a voltage between the first auxiliary cell 214 and the second auxiliary cell 216 depending upon the applied current. In this case, variation in the measured voltage may be substantially regarded as voltage variation due to the second auxiliary cell 216, since the unclosed auxiliary cell passes a larger amount of electrolyte solution therethrough than the closed auxiliary cell. In addition, even when both auxiliary cells 214, 216 are closed, the same analysis results may be obtained as the result obtained when one auxiliary cell is closed.

5) The analysis unit 232 creates a graph showing a variation in the voltage between the first auxiliary cell 214 and the second auxiliary cell 216 according to measurement time. The analysis unit 232 detects a first inflection section and a second inflection section of the voltage, and The analysis unit 232 detects a first measurement time intervals for the first inflection section and a second measurement time for the second inflection section in the created graph.

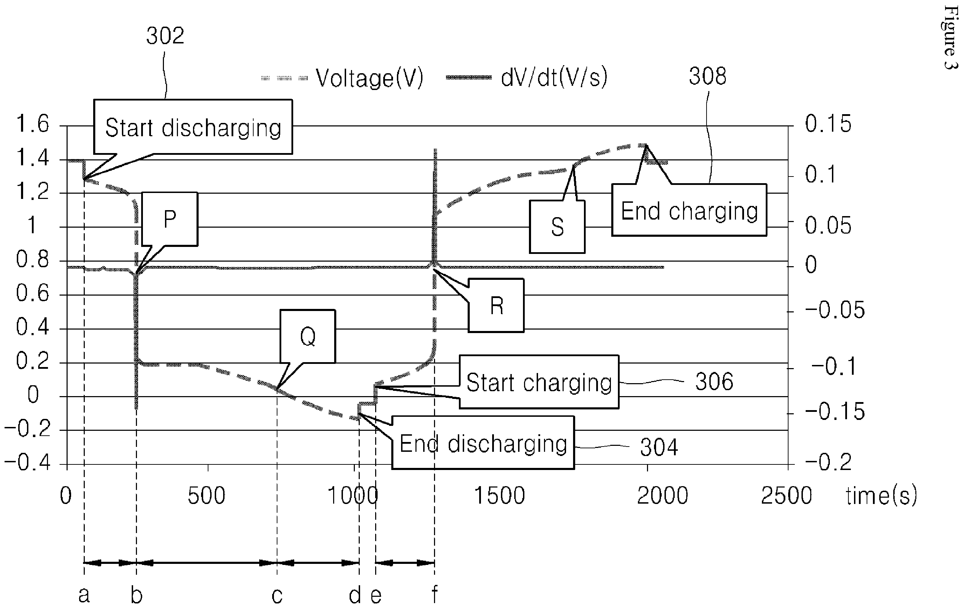

Figure 3 shows a graph created by the analysis unit 232 through the aforementioned process. In the created graph, the analysis unit 232 may detect four inflection points P, Q, R, S where voltage is drastically changed. For reference, the analysis unit 232 may detect the inflection points in the graph using one of several well-known inflection point detection algorithms.

In Figure 3, a section between a discharge start point and the first inflection point P is defined as a first inflection section (a-b), and a section between the first inflection point P and the second inflection point Q is defined as a second inflection section (b-c). In the first inflection section (a-b), $V^{4+}$ and $V^{5+}$ ions are present in an electrolyte solution, and at the first inflection point P, $V^{5+}$ ions are all changed to $V^{4+}$ ions. In the second inflection section (b-c), $V^{3+}$ and $V^{4+}$ ions are present in the electrolyte solution, and at the second inflection point Q, $V^{4+}$ ions are all changed to $V^{3+}$ ions.

The analysis unit 232 acquires a first measurement time interval for the first inflection section (a-b) by subtracting time (a) corresponding to the discharge start point from time (b) corresponding to the first inflection point P. In addition, the analysis unit 232 acquires a second measurement time interval for the second inflection section (b-c) by subtracting the time (b) corresponding to the first inflection point P from time (c) corresponding to the second inflection point Q. Based on the obtained first measurement time interval and the obtained second measurement time interval, the analysis unit 232 may calculate the amount of electrolytes (vanadium ions) contained in the second electrolyte solution as follows:

$$\text{Amount of electrolyte (Ah)} = I \times B,$$

where I is the magnitude of the current applied to the first auxiliary cell and the second auxiliary cell, and B is the second measurement time interval.

For example, when I = 2 A, b = 250.3 s, and c = 822.0 s,
B=c-b=571.7
IxB=2x571.7=1143.4

For conversion into a capacity unit, the resulting value is divided by 3600 s/h as follows: 1143.4/3600 = 0.318 Ah.

Thus, the calculated amount of electrolytes contained in the second electrolyte solution is 1143.4 and the capacity of the electrolytes is 0.318 Ah.

Using the obtained capacity of the electrolytes contained in the second electrolyte solution confined in the second auxiliary cell 216, the entire capacity of the electrolytes contained in the second electrolyte solution stored in the storage tank 114 may also be calculated by the following relational expression:

Volume of the second electrolyte solution confined in the second auxiliary cell 216 : Volume of the second electrolyte solution stored in the storage tank 114 = Capacity of the electrolytes contained in the second electrolyte solution confined in the second auxiliary cell 216 : Capacity of the electrolytes contained in the second electrolyte solution stored in the storage tank 114

In addition, the analysis unit 232 may calculate the oxidation number of the electrolytes (vanadium ions) contained in the second electrolyte solution as follows:

$$\text{Oxidation number of electrolyte} = 4 + A/B,$$

where A is the first measurement time interval and B is the second measurement time interval.

Here, 4 is a predetermined constant, which may be changed depending upon examples and the type of used electrolyte.

For example, when a = 60.0 s, b = 250.3 s, and c = 822.0 s,
A=b-a= 190.3
B=c-b=571.7

The oxidation number of the electrolytes contained in the second electrolyte solution is calculated as follows:
4 + A/B = 4 + 190. 3/571.7 = 4 + 0.33 = 4.33.

In some examples, the second measurement time interval (b-c) may be difficult to detect due to an indefinite location of the second inflection point Q in the graph of Figure 3. In this case, the second measurement time interval (b-c) may be obtained through other methods. In the graph of Figure 3, a measurement time interval for a section c-d is the same as that for a section d-f. Therefore, the measurement time interval for the section b-c, namely, the second measurement time interval may be obtained by subtracting the measurement time interval for the section d-f from that for a section b-d.

### Example 2

Through the following process, the analysis module 226 analyzes a first electrolyte solution flowing into the first auxiliary cell 214. The analysis process in Example 2 proceeds similarly to that in Example 1.

1) The auxiliary cell controller 228 opens all the valves 206, 208, 210, 212 to allow a first electrolyte solution and a second electrolyte solution to flow into the first auxiliary cell 214 and the second auxiliary cell 216. In other examples in which the separate internal lines are further formed as described above in addition to the internal lines 222, 224 shown in Figure 2, the auxiliary cell controller 228 may also allow electrolyte solutions having the same polarity to flow into the first auxiliary cell 214 and the second auxiliary cell 216.

2) The auxiliary cell controller 228 closes the valves 206, 210 to confine the first electrolyte solution in the first auxiliary cell 214. In other examples, the auxiliary cell controller 228 may also close all the valves 206, 208, 210, 212 of the first auxiliary cell 214 and the second auxiliary cell 216.

3) The current controller 230 applies current to the first auxiliary cell 214 functioning as an anode and the second auxiliary cell 216 functioning as a cathode. Discharge starts (402) when a current of 2A is applied at a voltage of about 1.3 V to the first auxiliary cell 214 and the second auxiliary cell 216 and ends (404) when a voltage between the two auxiliary cells is about -0.15 V. Thereafter, charging starts (406) when a current of 2A having an opposite polarity is applied to the two auxiliary cells again and ends (408) at a voltage of 1.5 V. Although a current of 2A is applied to the two auxiliary cells in this example, the magnitude of the applied current may be changed according to examples.

4) The current controller 230 measures a voltage between the first auxiliary cell 214 and the second auxiliary cell 216 depending upon the applied current. In this case, a variation in the measured voltage may be substantially regarded as a voltage variation due to the first auxiliary cell 216, since the unclosed auxiliary cell passes a larger amount of electrolyte solution therethrough than the closed auxiliary cell. In addition, even when the two auxiliary cells 214, 216 are both closed, the same analysis results may be obtained as the result obtained when one auxiliary cell is closed.

5) The analysis unit 232 creates a graph showing a variation in the voltage between the first auxiliary cell 214 and the second auxiliary cell 216 according to measurement time. The analysis unit 232 detects a first inflection section and a second inflection section of the voltage, and The analysis unit 232 detects a first measurement time interval for the first inflection section and a second measurement time interval for the second inflection section.

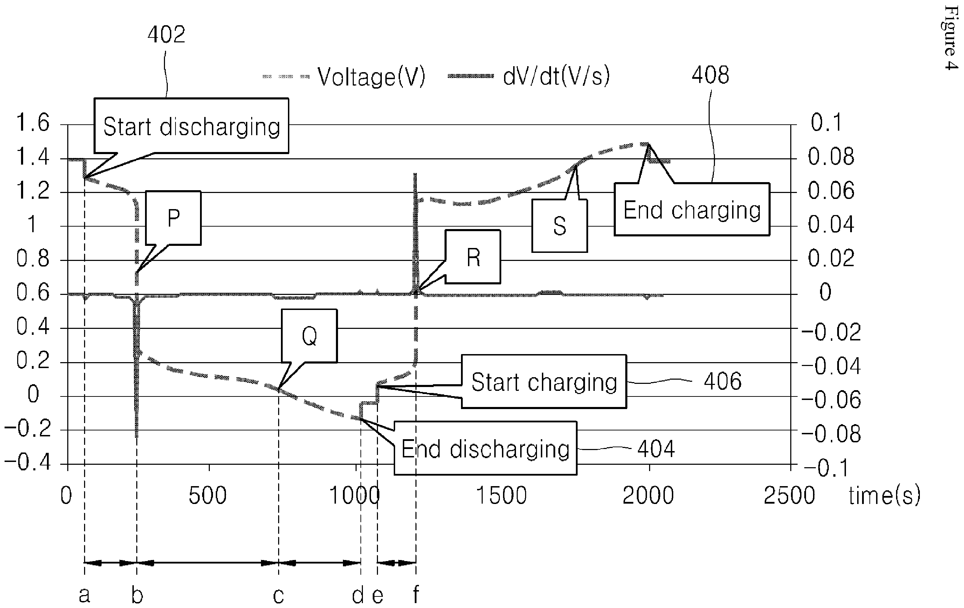

Figure 4 shows a graph created by the analysis unit 232 through the aforementioned process. Through the created graph, the analysis unit 232 may detect four inflection points P, Q, R, S where the voltage is drastically changed. For reference, the analysis unit 232 may detect the inflection points in the graph using one of several well-known inflection point detection algorithms.

In Figure 4, a section between a discharge start point and the first inflection point P is defined as a first inflection section (a-b), and a section between the first inflection point P and the second inflection point Q is defined as a second inflection section (b-c). In the first inflection section (a-b), $V^{2+}$ and $V^{3+}$ ions are present in an electrolyte solution, and at the first inflection point P, $V^{2+}$ ions are all changed to $V^{3+}$ ions. In the second inflection section (b-c), $V^{3+}$ and $V^{4+}$ ions are present in the electrolyte solution, and at the second inflection point Q, $V^{3+}$ ions are all changed to $V^{4+}$ ions.

The analysis unit 232 acquires a first measurement time interval for the first inflection section (a-b) by subtracting time (a) corresponding to the discharge start point from time (b) corresponding to the first inflection point P. In addition, the analysis unit 232 acquires a second measurement time interval for the second inflection section (b-c) by subtracting the time (b) corresponding to the first inflection point P from time (c) corresponding to the second inflection point Q.

Based on the obtained first and second measurement time intervals, the analysis unit 232 may calculate the amount of electrolytes (vanadium ions) contained in the first electrolyte solution as follows:

$$\text{Amount of electrolyte (Ah)} = I \times B,$$

where I is the magnitude of the current applied to the first auxiliary cell and the second auxiliary cell, and B is the second measurement time interval.

For example, when I = 2 A, b = 295.4 s, and c = 884.7 s,

B = c - b = 589.3

I x B = 2 x 589.3 = 1178.6

For conversion into a capacity unit, the resulting value is divided by 3600 s/h as follows: 1178.6 / 3600 = 0.327 (Ah).

Thus, the calculated amount of electrolytes contained in the first electrolyte solution is 1178.6 and the capacity of the electrolytes is 0.327 Ah.

Using the obtained capacity of the electrolytes contained in the first electrolyte solution confined in the first auxiliary cell 214, the entire capacity of the electrolytes contained in the first electrolyte solution stored in the storage tank 112 may also be calculated by the following relational expression:

$$\text{Volume of the first electrolyte solution confined in the first auxiliary cell 214 :}$$
$$\text{Volume of the first electrolyte solution stored in the storage tank 112 = Capacity of the}$$
$$\text{electrolytes contained in the first electrolyte solution confined in the first auxiliary cell}$$
$$\text{214 : Capacity of the electrolytes contained in the first electrolyte solution stored in the}$$
$$\text{storage tank 112}$$

In addition, the analysis unit 232 may calculate the oxidation number of the electrolytes (vanadium ions) contained in the first electrolyte solution as follows:

$$\text{Oxidation number of electrolyte} = 3 - A/B$$

where A is the first measurement time interval, and B is the second measurement time interval.

Here, 3 is a predetermined constant, which may be changed depending upon examples and the type of used electrolyte.

For example, when a = 60.0 s, b = 295.4 s, and c = 884.7 s,

A = b - a = 235.4

B = c - b = 589.3

The oxidation number of the electrolytes contained in the first electrolyte solution is calculated as follows: 3 - A/B = 3 - 235.4/589.3 = 3 - 0.40 = 2.60.

In some examples, the second measurement time interval (b-c) may be difficult to detect due to an indefinite location of the second inflection point Q in the graph of Figure 3. In this case, the second measurement time interval (b-c) may be obtained through other methods. In the graph of Figure 4, a measurement time interval for a section c-d is the same as that for a section d-f. Therefore, the measurement time interval for the section b-c, namely, the second measurement time interval may be obtained by subtracting the measurement time interval for the section d-f from that for a section b-d.

## Example 3

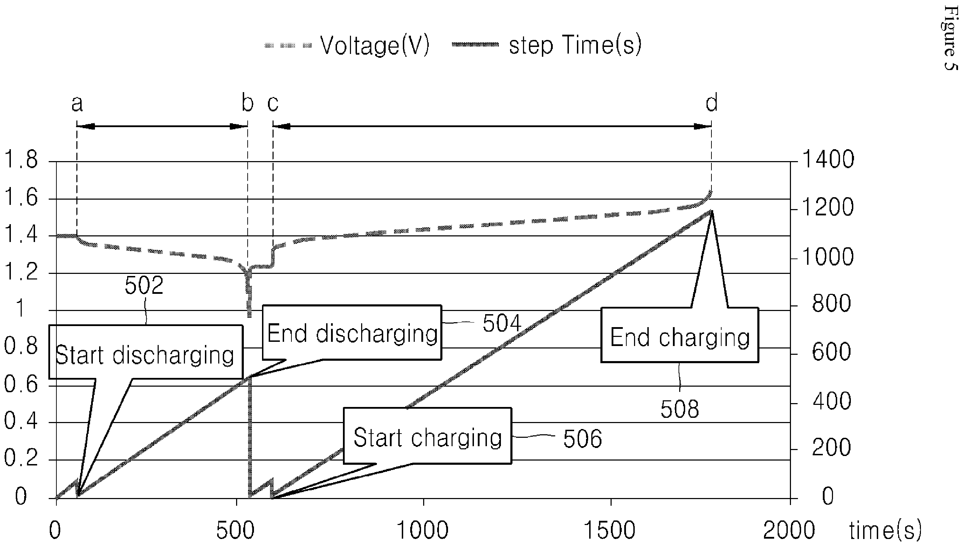

Through the following process, the analysis module 226 analyzes a second electrolyte solution flowing into the second auxiliary cell 216. Figure 5 shows a graph created through the following process.

1) The auxiliary cell controller 228 opens all the valves 206, 208, 210, 212 to allow a first electrolyte solution and a second electrolyte solution to flow into the first auxiliary cell 214 and the second auxiliary cell 216. In other examples in which the separate internal lines are further formed as described above in addition to the internal lines 222, 224 shown in Figure 2, the auxiliary cell controller 228 may also allow electrolyte solutions having the same polarity to flow into the first auxiliary cell 214 and the second auxiliary cell 216.

2) The auxiliary cell controller 228 closes the valves 208, 212 to confine the second electrolyte solution in the second auxiliary cell 216. In other examples, the auxiliary cell controller 228 may also close all the valves 206, 208, 210, 212 of the first auxiliary cell 214 and the second auxiliary cell 216.

3) The current controller 230 applies a current of 1 A to the first auxiliary cell 214 and the second auxiliary cell 216 for a first completion time interval for which a voltage between the first auxiliary cell 214 and the second auxiliary cell 216 reaches a first voltage value (e.g., 1 V) from a current voltage value (e.g., 1.4 V) (Start discharging (502) and End discharging (504)). In Figure 5, the first completion time interval is defined by subtraction of discharge start time (a) from discharge end time (b).

4) The current controller 230 applies a current of 1 A to the first auxiliary cell 214 and the second auxiliary cell 216 for a second completion time interval for which the voltage between the first auxiliary cell 214 and the second auxiliary cell 216 reaches a second voltage value (e.g., 1.65 V) from a current voltage value (e.g., 1 V) (start charging (506) and end charging (508)). In Figure 5, the second completion time interval is defined by subtraction of charging start time (c) from charging end time (d).

5) The analysis unit 232 analyzes electrolytes contained in the second electrolyte solution, based on the first completion time interval and the second completion time interval. For example, the analysis unit 232 may calculate the amount and the oxidation number of the electrolytes contained in the second electrolyte solution as follows:

$$\text{Amount of electrolyte} = I \times F,$$

where I is the magnitude of the current applied to the first auxiliary cell and the second auxiliary cell, and F is the second completion time interval.

$$\text{Oxidation number of electrolyte} = 4 + E/F,$$

where E is the first completion time interval, and F is the second completion time interval.

Here, 4 is a predetermined constant, which may be changed depending upon examples and the type of used electrolyte.

In Example 3, charging 506, 508 is performed after discharging 502, 504, as shown in Figure 5. However, in other examples, though discharging is performed after charging, the same analysis results may be obtained. In this case, the oxidation number of the electrolytes is determined as follows:

$$\text{Oxidation number of electrolyte} = 5 - E/F,$$

where E is the first completion time interval and F is the second completion time interval.

Here, 5 is a predetermined constant, which may be changed depending upon examples and the type of used electrolyte.

## Example 4

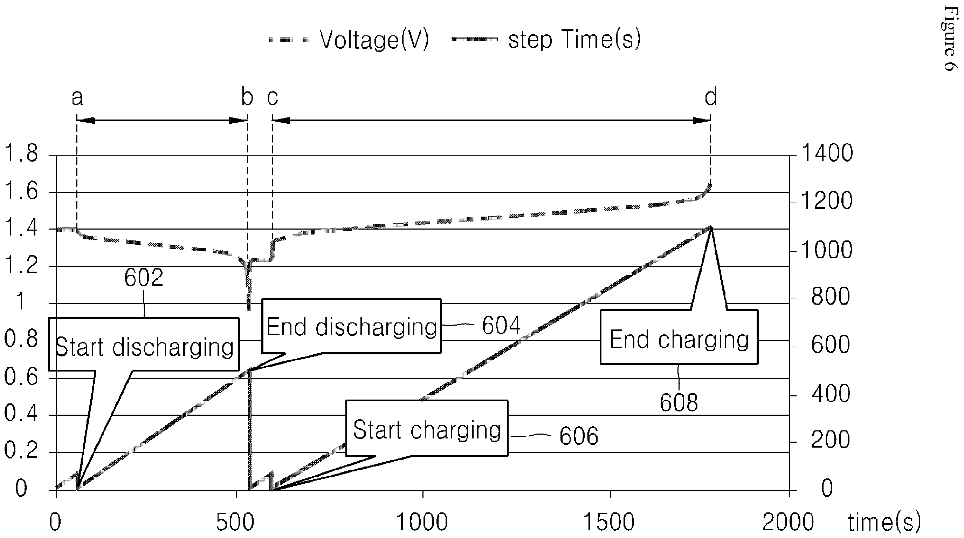

Through the following process, the analysis module 226 analyzes a first electrolyte solution flowing into the first auxiliary cell 214. Figure 6 shows a graph created through the following process.

1) The auxiliary cell controller 228 opens all the valves 206, 208, 210, 212 to allow a first electrolyte solution and a second electrolyte solution to flow into the first auxiliary cell 214 and the second auxiliary cell 216. In other examples in which the separate internal lines are further formed as described above in addition to the internal lines 222, 224 shown in Figure 2, the auxiliary cell controller 228 may also allow electrolyte solutions having the same polarity to flow into the first auxiliary cell 214 and the second auxiliary cell 216.

2) The auxiliary cell controller 228 closes the valves 206, 210 to confine the first electrolyte solution in the first auxiliary cell 214. In other examples, the auxiliary cell controller 228 may also close all the valves 206, 208, 210, 212 of the first auxiliary cell 214 and the second auxiliary cell 216.

3) The current controller 230 applies a current of 1 A to the first auxiliary cell 214 and the second auxiliary cell 216 for a first completion time interval for which a voltage between the first auxiliary cell 214 and the second auxiliary cell 216 reaches a first voltage value (e.g., 1 V) from a current voltage value (e.g., 1.4 V) (Start discharging (602) and End discharging (604)). In Figure 6, the first completion time interval is defined by subtraction of discharge start time (a) from discharge end time (b).

4) The current controller 230 applies a current of 1 A to the first auxiliary cell 214 and the second auxiliary cell 216 for a second completion time interval for which the voltage between the first auxiliary cell 214 and the second auxiliary cell 216 reaches a second voltage value (e.g., 1.65 V) from a current voltage value (e.g., 1 V) (Start charging (606) and End charging (608)). In Figure 6, the second completion time interval is defined by subtraction of charging start time (c) from charging end time (d).

5) The analysis unit 232 analyzes electrolytes contained in the first electrolyte solution, based on the first completion time interval and the second completion time interval. For example, the analysis unit 232 may calculate the amount and the oxidation number of the electrolytes contained in the first electrolyte solution as follows:

$$\text{Amount of electrolyte} = I \times F,$$

where I is the magnitude of current applied to the first auxiliary cell and the second auxiliary cell, and F is the second completion time interval.

$$\text{Oxidation number of electrolyte} = 3 - E/F,$$

where E is the first completion time interval, and F is the second completion time interval.

Here, 3 is a predetermined constant, which may be changed depending upon examples and the type of used electrolyte.

In Example 4, charging 606, 608 is performed after discharging 602, 604, as shown in Figure 6. However, in other examples, though discharging is performed after charging, the same analysis results may be obtained. In this case, the oxidation number of the electrolytes is determined as follows:

$$\text{Oxidation number of electrolyte} = 2 + E/F,$$

where E is the first completion time interval, and F is the second completion time interval.

Here, 2 is a predetermined constant, which may be changed depending upon examples and the type of used electrolyte..

## Example 5

Example 5 is an application example of Examples 1 and 2. In Examples 1 and 2, measurement is conducted while an electrolyte solution is confined in one of the first auxiliary cell 214 and the second auxiliary cell 216. However, in Example 5, measurement is conducted while electrolyte solutions are confined in the closed first auxiliary cell 214 and the closed second auxiliary cell 216.

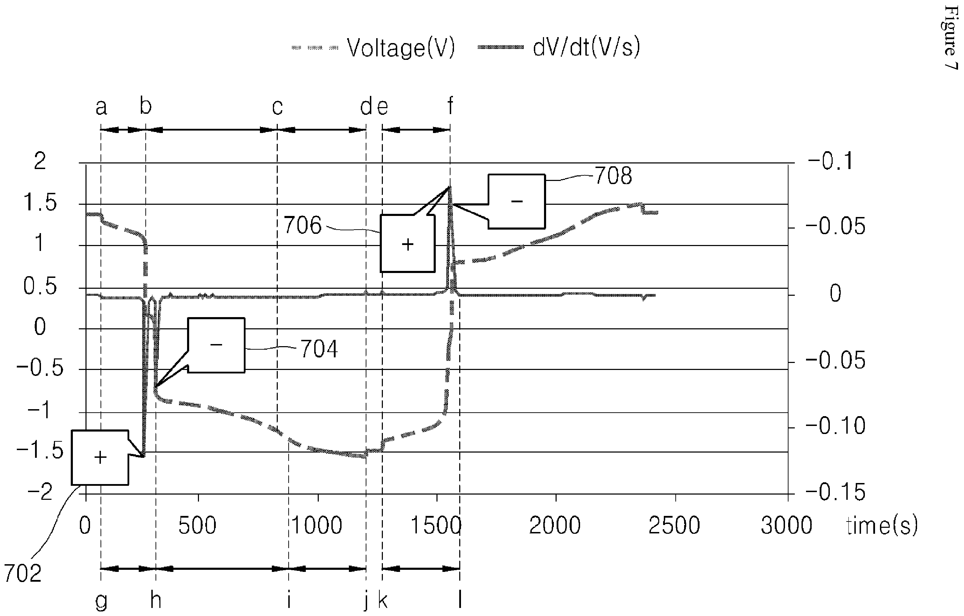

For example, in Example 5, measurement may be conducted through the following process. Figure 7 shows a graph created through the following process.

1) The auxiliary cell controller 228 opens all the valves 206, 208, 210, 212 to allow a first electrolyte solution and a second electrolyte solution to flow into the first auxiliary cell 214 and the second auxiliary cell 216.
2) The auxiliary cell controller 228 closes all the valves 206, 208, 210, 212 to confine the first electrolyte solution and the second electrolyte solution in the first auxiliary cell 214 and the second auxiliary cell 216.
3) The current controller 230 applies a current of 2 A to the first auxiliary cell 214 functioning as an anode and the second auxiliary cell 216 functioning as a cathode (discharging to a voltage of -1.5 V). Therefore, two inflection points 702, 704 are detected.
4) The current controller 230 applies a current of 2 A to the first auxiliary cell 214 functioning as a cathode and the second auxiliary cell 216 functioning as an anode (charging to a voltage of 1.5 V). Therefore, two other inflection points 706, 708 are detected.

Using the inflection points detected as shown in Figure 7 and inflection sections according to the inflection points, the analysis unit 232 may calculate the amount, capacity, and oxidation number of electrolytes contained in the anolyte and catholyte solutions as follows:

$$\text{Amount of electrolyte in anolyte solution} = I \times (c - b)$$

$$\text{Capacity of electrolyte in anolyte solution} = I \times (c - b) / 3600$$

$$\text{Oxidation number of anolyte solution} = 4 + (b - a) / (c - b)$$

$$\text{Amount of electrolyte in catholyte solution} = I \times (i - h)$$

$$\text{Capacity of electrolyte in catholyte solution} = I \times (i - h) / 3600$$

$$\text{Oxidation number of catholyte solution} = 3 - (h - g) / (i - h)$$

In order to clearly identify whether the detected inflection points are caused by the anolyte or catholyte solution, analysis may be conducted two or more times in Example 5 while changing the amount of electrolytes confined in the first auxiliary cell 214 and the second auxiliary cell 216. In addition, an auxiliary device such as a UV device may be used to identify the inflection points.

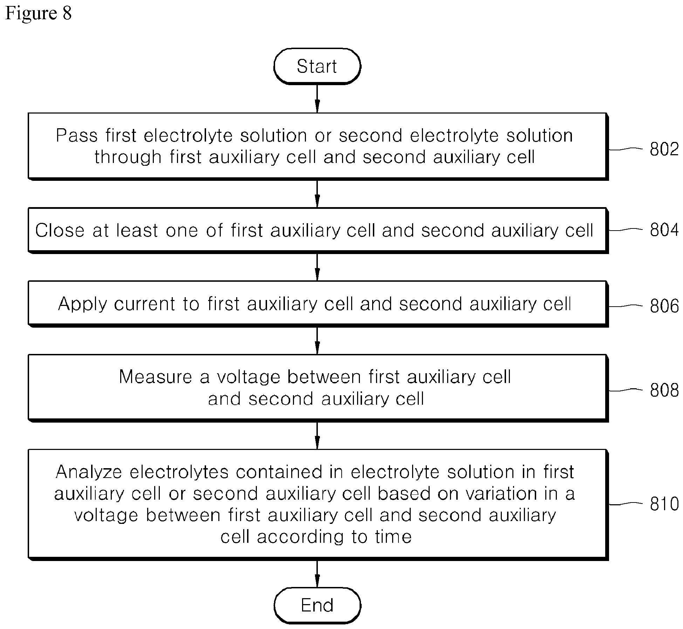

Figure 8 is a flowchart of an electrolyte analysis method according to one embodiment of the present invention.

A first electrolyte solution or a second electrolyte solution passes through each of a first auxiliary cell and a second auxiliary cell connected to a main cell and a storage tank (Step 802). At least one of the first auxiliary cell and the second auxiliary cell is closed (Step 804).

Current is applied to the first auxiliary cell and the second auxiliary cell (Step 806) and a voltage between the first auxiliary cell and the second auxiliary cell is measured (Step 808). Electrolytes contained in the electrolyte solution in the first auxiliary cell or the second auxiliary cell are analyzed based on variation in voltage between the first auxiliary cell and the second auxiliary cell depending upon time (Step 810).

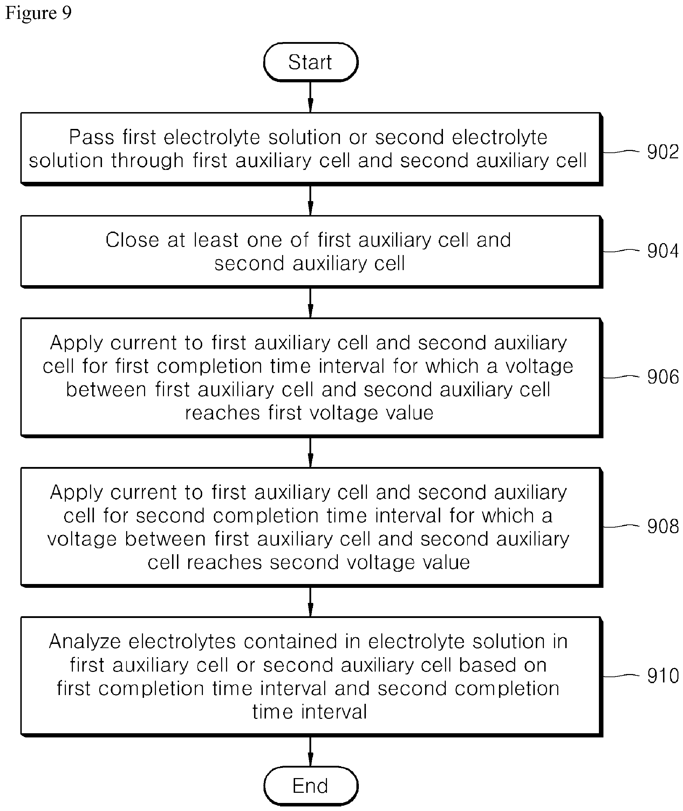

Figure 9 is a flowchart of an electrolyte analysis method according to another embodiment of the present invention.

A first electrolyte solution or a second electrolyte solution passes through each of a first auxiliary cell and a second auxiliary cell connected to a main cell and a storage tank (Step 902). At least one of the first auxiliary cell and the second auxiliary cell is closed (Step 904).

Current is applied to the first auxiliary cell and the second auxiliary cell for a first completion time interval for which a voltage between the first auxiliary cell and the second auxiliary cell reaches a first voltage value (Step 906), and current is applied to the first auxiliary cell and the second auxiliary cell for a second completion time interval for which the voltage between the first auxiliary cell and the second auxiliary cell reaches a second voltage value (Step 908). Electrolytes contained in the electrolyte solution in the first auxiliary cell or the second auxiliary cell are analyzed based on the first completion time interval and the second completion time interval (Step 910).

Although some embodiments have been described herein, it should be understood that various modifications, changes, alterations, and equivalent embodiments can be made by those skilled in the art. Therefore, the scope of the invention should be limited only by the accompanying claims and equivalents thereof.

## Claims

1. A method of analyzing an electrolyte of a redox flow battery, comprising:

    passing a first electrolyte solution or a second electrolyte solution through each of a first auxiliary cell and a second auxiliary cell connected to a main cell and a storage tank;
    closing only one of the first auxiliary cell and the second auxiliary cell in order to confine electrolyte in one of the first auxiliary cell or the second auxiliary cell;
    applying current to the first auxiliary cell and the second auxiliary cell;
    creating data by measuring a voltage between the first auxiliary cell and the second auxiliary cell; and
    analyzing an electrolyte contained in a closed auxiliary cell based on variation in the voltage between the first auxiliary cell and the second auxiliary cell according to time.

2. The method according to claim 1, wherein analyzing the electrolyte comprises:

    detecting first inflection section and second inflection section of the voltage in a graph deduced from data representing the voltage variation between the first auxiliary cell and the second auxiliary cell according to time; and
    detecting a first measurement time interval for the first inflection section and a second measurement time interval for the second inflection section.

3. The method according to claim 2, wherein analyzing the electrolyte further comprises:

calculating the amount of electrolyte by Equation 1:

[Equation 1]

$$\text{Amount of electrolyte} = I \times B,$$

where I is magnitude of the current applied to the first auxiliary cell and the second auxiliary cell, and B is the second measurement time interval.

4. The method according to claim 2, wherein analyzing the electrolyte comprises:

when the electrolyte solution in the closed auxiliary cell comprises an anolyte solution, calculating an oxidation number of the electrolyte by Equation 2:

[Equation 2]

$$\text{Oxidation number of electrolyte} = X1 + A/B,$$

where X1 is a predetermined constant, A is the first measurement time interval, and B is the second measurement time interval.

5. The method according to claim 2, wherein analyzing the electrolyte comprises:

when the electrolyte solution in the closed auxiliary cell comprises a catholyte solution, calculating an oxidation number of the electrolyte by Equation 3:

[Equation 3]

$$\text{Oxidation number of electrolyte} = X2 - A/B,$$

where X2 is a predetermined constant, A is the first measurement time interval, and B is the second measurement time interval.

6. A method according to claim 1, wherein the steps of applying current, creating data and analyzing an electrolyte comprise:

applying current to the first auxiliary cell and the second auxiliary cell for a first completion time interval for which a voltage between the first auxiliary cell and the second auxiliary cell reaches a first voltage value; applying current to the first auxiliary cell and the second auxiliary cell for a second completion time interval for which the voltage between the first auxiliary cell and the second auxiliary cell reaches a second voltage value; and analyzing an electrolyte contained in the electrolyte solution in the closed auxiliary cell based on the first completion time and the second completion time intervals.

7. The method according to claim 6, wherein analyzing the electrolyte comprises:

calculating the amount of electrolyte by Equation 4:

[Equation 4]

$$\text{Amount of electrolyte} = I \times F,$$

where I is magnitude of the current applied to the first auxiliary cell and the second auxiliary cell, and F is the second completion time interval.

8. The method according to claim 6, wherein analyzing the electrolyte comprises:

when the electrolyte solution in the closed auxiliary cell comprises an anolyte solution, calculating an oxidation number of the electrolyte by Equation 5:

$$[\text{Equation 5}]$$

$$\text{Oxidation number of electrolyte} = X3 + E/F,$$

where X3 is a predetermined constant, E is the first completion time interval, and F is the second completion time interval.

9. The method according to claim 6, wherein analyzing the electrolyte comprises:

when the electrolyte solution in the closed auxiliary cell comprises an anolyte solution, calculating an oxidation number of the electrolyte by Equation 6:

$$[\text{Equation 6}]$$

$$\text{Oxidation number of electrolyte} = X4 - E/F,$$

where X4 is a predetermined constant, E is the first completion time interval, and F is the second completion time interval.

10. The method according to claim 6, wherein analyzing the electrolyte comprises:

when the electrolyte solution in the closed auxiliary cell comprises a catholyte solution, calculating an oxidation number of the electrolyte by Equation 7:

$$[\text{Equation 7}]$$

$$\text{Oxidation number of electrolyte} = X5 - E/F,$$

where X5 is a predetermined constant, E is the first completion time interval, and F is the second completion time interval.

11. The method according to claim 6, wherein analyzing the electrolyte comprises:

when the electrolyte solution in the closed auxiliary cell comprises a catholyte solution, calculating an oxidation number of the electrolyte by Equation 8:

$$[\text{Equation 8}]$$

$$\text{Oxidation number of electrolyte} = X6 + E/F,$$

where X6 is a predetermined constant, E is the first completion time interval, and F is the second completion time interval.

**Patentansprüche**

1. Verfahren zum Analysieren eines Elektrolyten einer Redox-Durchflussbatterie, umfassend:

Leiten einer ersten Elektrolytlösung oder einer zweiten Elektrolytlösung durch jede einer ersten Hilfszelle und einer zweiten Hilfszelle, welche mit einer Hauptzelle und einem Lagertank verbunden ist;

Schließen lediglich einer der ersten Hilfszelle und der zweiten Hilfszelle, um den Elektrolyten in einer der ersten Hilfszelle oder der zweiten Hilfszelle zu beschränken;

Anlegen von Strom auf die erste Hilfszelle und die zweite Hilfszelle;

Erstellen von Daten durch das Messen einer Spannung zwischen der ersten Hilfszelle und der zweiten Hilfszelle; und

Analysieren eines Elektrolyten, welcher in einer geschlossenen Hilfszelle enthalten ist, auf der Basis einer Spannungsschwankung zwischen der ersten Hilfszelle und der zweiten Hilfszelle nach Zeit.

2. Verfahren nach Anspruch 1, wobei das Analysieren des Elektrolyten Folgendes umfasst:

Erfassen eines ersten Beugungsabschnitts und eines zweiten Beugungsabschnitts der Spannung in einer Kurve, die von Daten, die die Spannungsschwankung zwischen der ersten Hilfszelle und der zweiten Hilfszelle nach Zeit abgleitet sind; und

Erfassen eines ersten Messungszeitintervalls für den ersten Beugungsabschnitt und eines zweiten Messungszeitintervalls für den zweiten Beugungsabschnitt.

3. Verfahren nach Anspruch 2, wobei das Analysieren des Elektrolyten ferner Folgendes umfasst:

Kalkulieren der Menge von Elektrolyt durch die Gleichung 1:

$$[\text{Gleichung 1}]$$
$$\text{Menge von Elektrolyt} = I \times B,$$

wobei I die auf die erste Hilfszelle und die zweite Hilfszelle angelegte Stromstärke ist, und B das zweite Messungszeitintervall ist.

4. Verfahren nach Anspruch 2, wobei das Analysieren des Elektrolyten Folgendes umfasst:

wenn die Elektrolytlösung in der geschlossenen Hilfszelle eine Anolytlösung enthält, Kalkulieren einer Oxidationszahl des Elektrolyten durch die Gleichung 2:

$$[\text{Gleichung 2}]$$
$$\text{Oxidationszahl von Elektrolyt} = X1 + A/B,$$

wobei X1 eine vorgegebene Konstante ist, A das erste Messungszeitintervall ist, und B das zweite Messungszeitintervall ist.

5. Verfahren nach Anspruch 2, wobei das Analysieren des Elektrolyten Folgendes umfasst:

wenn die Elektrolytlösung in der geschlossenen Hilfszelle eine Katholytlösung enthält, Kalkulieren einer Oxidationszahl des Elektrolyten durch die Gleichung 3:

$$[\text{Gleichung 3}]$$
$$\text{Oxidationszahl von Elektrolyt} = X2 - A/B,$$

wobei X2 eine vorgegebene Konstante ist, A das erste Messungszeitintervall ist, und B das zweite Messungszeitintervall ist.

6. Verfahren nach Anspruch 1, wobei die Schritte umfassend das Anlegen von Strom, das Erstellen von Daten und das Analysieren eines Elektrolyten umfassen:

Anlegen eines Stroms auf die erste Hilfszelle und die zweite Hilfszelle für ein erstes Beendigungszeitintervall, für welches eine Spannung zwischen der ersten Hilfszelle und der zweiten Hilfszelle einen ersten Spannungswert erreicht;

Anlegen eines Stroms auf die erste Hilfszelle und die zweite Hilfszelle für ein zweites Beendigungszeitintervall, für welches die Spannung zwischen der ersten Hilfszelle und der zweiten Hilfszelle einen zweiten Spannungswert erreicht; und

Analysieren eines in der Elektrolytlösung in der geschlossenen Hilfszelle enthaltenen Elektrolyten auf der Basis des ersten Beendigungszeitintervalls und des zweiten Beendigungszeitintervalls.

7. Verfahren nach Anspruch 6, wobei das Analysieren des Elektrolyten Folgendes umfasst:

Kalkulieren der Menge von Elektrolyt durch die Gleichung 4:

$$[\text{Gleichung 4}]$$
$$\text{Menge von Elektrolyt} = I \times F,$$

wobei I die auf die erste Hilfszelle und die zweite Hilfszelle angelegte Stromstärke ist, und F das zweite Messungszeitintervall ist.

8. Verfahren nach Anspruch 6, wobei das Analysieren des Elektrolyten Folgendes umfasst:

wenn die Elektrolytlösung in der geschlossenen Hilfszelle eine Anolytlösung enthält, Kalkulieren einer Oxidationszahl des Elektrolyten durch die Gleichung 5:

$$[\text{Gleichung 5}]$$
$$\text{Oxidationszahl von Elektrolyt} = X3 + E/F,$$

wobei X3 eine vorgegebene Konstante ist, E das erste Beendigungszeitintervall ist, und F das zweite Beendigungszeitintervall ist.

9. Verfahren nach Anspruch 6, wobei das Analysieren des Elektrolyten Folgendes umfasst:

wenn die Elektrolytlösung in der geschlossenen Hilfszelle eine Anolytlösung enthält, Kalkulieren einer Oxidationszahl des Elektrolyten durch die Gleichung 6:

$$[\text{Gleichung 6}]$$
$$\text{Oxidationszahl von Elektrolyt} = X4 - E/F,$$

wobei X4 eine vorgegebene Konstante ist, E das erste Beendigungszeitintervall ist, und F das zweite Beendigungszeitintervall ist.

10. Verfahren nach Anspruch 6, wobei das Analysieren des Elektrolyten Folgendes umfasst:

wenn die Elektrolytlösung in der geschlossenen Hilfszelle eine Katholytlösung enthält, Kalkulieren einer Oxidationszahl des Elektrolyten durch die Gleichung 7:

$$[\text{Gleichung 7}]$$
$$\text{Oxidationszahl von Elektrolyt} = X5 - E/F,$$

wobei X5 eine vorgegebene Konstante ist, E das erste Beendigungszeitintervall ist, und F das zweite Beendigungszeitintervall ist.

11. Verfahren nach Anspruch 6, wobei das Analysieren des Elektrolyten Folgendes umfasst:

wenn die Elektrolytlösung in der geschlossenen Hilfszelle eine Katholytlösung enthält, Kalkulieren einer Oxidationszahl des Elektrolyten durch die Gleichung 8:

[Gleichung 8]

Oxidationszahl von Elektrolyt = X6 + E/F,

wobei X6 eine vorgegebene Konstante ist, E das erste Beendigungszeitintervall ist, und F das zweite Beendigungszeitintervall ist.

**Revendications**

1.  Procédé pour analyser un électrolyte de batterie à flux redox, comprenant les étapes:

    faire passer une première solution d'électrolyte ou une deuxième solution d'électrolyte à travers chacun d'une première cellule auxiliaire et d'une deuxième cellule auxiliaire reliée à une cellule principale et un réservoir de stockage;
    fermer une seule de la première cellule auxiliaire et de la deuxième cellule auxiliaire afin de limiter l'électrolyte dans l'une de la première cellule auxiliaire et la deuxième cellule auxiliaire;
    appliquer un courant à la première cellule auxiliaire et à la deuxième cellule auxiliaire;
    créer des données en mesurant une tension entre la première cellule auxiliaire et la deuxième cellule auxiliaire; et
    analyser un électrolyte contenu dans une cellule auxiliaire fermée sur la base de la variation de la tension entre la première cellule auxiliaire et la deuxième cellule auxiliaire en fonction du temps.

2.  Procédé selon la revendication 1, dans lequel l'analyse de l'électrolyte comprend les étapes:

    détecter une première section d'inflexion et une deuxième section d'inflexion de la tension dans un graphique déduit de données représentant la variation de tension entre la première cellule auxiliaire et la deuxième cellule auxiliaire en fonction du temps; et
    détecter un premier intervalle de temps de mesure pour la première section d'inflexion et un deuxième intervalle de temps de mesure pour la deuxième section d'inflexion.

3.  Procédé selon la revendication 2, dans lequel l'analyse de l'électrolyte comprend en outre:

    le calcul de la quantité d'électrolyte par l'équation 1 :

    [Equation 1]

    Quantité d'électrolyte = I x B,

    où I est l'ampleur du courant appliqué à la première cellule auxiliaire et la deuxième cellule auxiliaire, et B est le deuxième intervalle de temps de mesure.

4.  Procédé selon la revendication 2, dans lequel l'analyse de l'électrolyte comprend:

    lorsque la solution d'électrolyte dans la première cellule auxiliaire fermée comprend une solution d'anolyte, le calcul d'un nombre d'oxydation de l'électrolyte par l'équation 2:

    [Equation 2]

    nombre d'oxydation de l'électrolyte = X1 + A/B,

    où X1 est une constante prédéterminée, A est le premier intervalle de temps de mesure, et B est le deuxième intervalle de temps de mesure.

5.  Procédé selon la revendication 2, dans lequel l'analyse de l'électrolyte comprend:

    lorsque la solution d'électrolyte dans la cellule auxiliaire fermée comprend une solution de catholyte, le calcul d'un nombre d'oxydation de l'électrolyte par l'équation 3:

[Equation 3]

nombre d'oxydation de l'électrolyte = X2 - A/B,

où X2 est une constante prédéterminée, A est le premier intervalle de temps de mesure, et B est le deuxième intervalle de temps de mesure.

6. Procédé selon la revendication 1, dans lequel les étapes à appliquer un courant, à créer des données et à analyser un électrolyte comprennent les étapes:

appliquer un courant à la première cellule auxiliaire et à la deuxième cellule auxiliaire pour un premier intervalle de temps d'achèvement pour lequel une tension entre la première cellule auxiliaire et la deuxième cellule auxiliaire atteint une première valeur de tension;
appliquer un courant à la première cellule auxiliaire et à la deuxième cellule auxiliaire pour un deuxième intervalle de temps d'achèvement pour lequel une tension entre la première cellule auxiliaire et la deuxième cellule auxiliaire atteint une deuxième valeur de tension; et
analyser un électrolyte contenu dans la solution d'électrolyte dans la cellule auxiliaire fermée sur la base du premier intervalle de temps d'achèvement et du deuxième intervalle de temps d'achèvement.

7. Procédé selon la revendication 6, dans lequel l'analyse de l'électrolyte comprend:

le calcul de la quantité d'électrolyte par l'équation 4:

[Equation 4]

Quantité d'électrolyte = I x F,

où I est l'ampleur du courant appliqué à la première cellule auxiliaire et la deuxième cellule auxiliaire, et F est le deuxième intervalle de temps d'achèvement.

8. Procédé selon la revendication 6, dans lequel l'analyse de l'électrolyte comprend:

lorsque la solution d'électrolyte dans la première cellule auxiliaire fermée comprend une solution d'anolyte, le calcul d'un nombre d'oxydation de l'électrolyte par l'équation 5:

[Equation 5]

nombre d'oxydation de l'électrolyte = X3 + E/F,

où X3 est une constante prédéterminée, E est le premier intervalle de temps d'achèvement, et F est le deuxième intervalle de temps d'achèvement.

9. Procédé selon la revendication 6, dans lequel l'analyse de l'électrolyte comprend:

lorsque la solution d'électrolyte dans la première cellule auxiliaire fermée comprend une solution d'anolyte, le calcul d'un nombre d'oxydation de l'électrolyte par l'équation 6:

[Equation 6]

nombre d'oxydation de l'électrolyte = X4 - E/F,

où X4 est une constante prédéterminée, E est le premier intervalle de temps d'achèvement, et F est le deuxième intervalle de temps d'achèvement.

10. Procédé selon la revendication 6, dans lequel l'analyse de l'électrolyte comprend:

lorsque la solution d'électrolyte dans la cellule auxiliaire fermée comprend une solution de catholyte, le calcul d'un nombre d'oxydation de l'électrolyte par l'équation 7:

[Equation 7]

nombre d'oxydation de l'électrolyte = X5 - E/F,

où X5 est une constante prédéterminée, E est le premier intervalle de temps d'achèvement, et F est le deuxième intervalle de temps d'achèvement.

11. Procédé selon la revendication 6, dans lequel l'analyse de l'électrolyte comprend:

lorsque la solution d'électrolyte dans la cellule auxiliaire fermée comprend une solution de catholyte, le calcul d'un nombre d'oxydation de l'électrolyte par l'équation 8:

[Equation 8]

nombre d'oxydation de l'électrolyte = X6 + E/F,

où X6 est une constante prédéterminée, E est le premier intervalle de temps d'achèvement, et F est le deuxième intervalle de temps d'achèvement.

Figure 1

Figure 2

Figure 3

Figure 4

Figure 5

## Figure 6

Figure 7

Figure 8

```
                        ┌─────────────┐
                        │    Start    │
                        └──────┬──────┘
                               │
    ┌──────────────────────────────────────────────────────────┐
    │  Pass first electrolyte solution or second electrolyte   │ ── 802
    │  solution through first auxiliary cell and second        │
    │  auxiliary cell                                          │
    └──────────────────────────┬───────────────────────────────┘
                               │
    ┌──────────────────────────────────────────────────────────┐
    │  Close at least one of first auxiliary cell and second   │ ── 804
    │  auxiliary cell                                          │
    └──────────────────────────┬───────────────────────────────┘
                               │
    ┌──────────────────────────────────────────────────────────┐
    │  Apply current to first auxiliary cell and second        │ ── 806
    │  auxiliary cell                                          │
    └──────────────────────────┬───────────────────────────────┘
                               │
    ┌──────────────────────────────────────────────────────────┐
    │  Measure a voltage between first auxiliary cell          │ ── 808
    │  and second auxiliary cell                               │
    └──────────────────────────┬───────────────────────────────┘
                               │
    ┌──────────────────────────────────────────────────────────┐
    │  Analyze electrolytes contained in electrolyte solution  │ ── 810
    │  in first auxiliary cell or second auxiliary cell based  │
    │  on variation in a voltage between first auxiliary cell  │
    │  and second auxiliary cell according to time             │
    └──────────────────────────┬───────────────────────────────┘
                               │
                        ┌──────┴──────┐
                        │     End     │
                        └─────────────┘
```

Figure 9

```
                        ( Start )
                            |
                            v
  +------------------------------------------------------+
  |   Pass first electrolyte solution or second electrolyte |---- 902
  | solution through first auxiliary cell and second auxiliary cell |
  +------------------------------------------------------+
                            |
                            v
  +------------------------------------------------------+
  |       Close at least one of first auxiliary cell and   |---- 904
  |                 second auxiliary cell                  |
  +------------------------------------------------------+
                            |
                            v
  +------------------------------------------------------+
  |   Apply current to first auxiliary cell and second auxiliary |
  |  cell for first completion time interval for which a voltage |---- 906
  |    between first auxiliary cell and second auxiliary cell   |
  |                 reaches first voltage value             |
  +------------------------------------------------------+
                            |
                            v
  +------------------------------------------------------+
  |   Apply current to first auxiliary cell and second auxiliary |
  |     cell for second completion time interval for which a    |---- 908
  |  voltage between first auxiliary cell and second auxiliary   |
  |           cell reaches second voltage value             |
  +------------------------------------------------------+
                            |
                            v
  +------------------------------------------------------+
  |  Analyze electrolytes contained in electrolyte solution in  |
  |    first auxiliary cell or second auxiliary cell based on   |---- 910
  |    first completion time interval and second completion    |
  |                      time interval                      |
  +------------------------------------------------------+
                            |
                            v
                        ( End )
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020130147530